# EUROPÄISCHE PATENTSCHRIFT

(11) **EP 3 186 408 B1**
(45) Veröffentlichungstag und Bekanntmachung des Hinweises auf die Patenterteilung: **17.07.2019**
(21) Anmeldenummer: 15750678.3
(22) Anmeldetag: 06.08.2015
(51) Int. Cl.: C23C 28/04, C23C 14/06, C23C 28/00, F16J 9/26, C23C 14/02, C23C 16/02, C23C 16/26, F02F 3/10

(54) **BESCHICHTUNG FÜR METALLBAUTEILE, VERFAHREN ZUM BESCHICHTEN EINES METALLBAUTEILS, KOLBEN FÜR VERBRENNUNGSKRAFTMASCHINEN UND KFZ**
COATING FOR METAL COMPONENTS, METHOD FOR COATING A METAL COMPONENT, PISTON FOR INTERNAL COMBUSTION ENGINES AND MOTOR VEHICLE
REVÊTEMENT POUR COMPOSANTS MÉTALLIQUES, PROCÉDÉ DE REVÊTEMENT D'UN COMPOSANT MÉTALLIQUE, PISTON POUR MOTEURS À COMBUSTION INTERNE ET VÉHICULE AUTOMOBILE

(30) Priorität: 27.08.2014 DE 102014217040
(43) Veröffentlichungstag der Anmeldung: 05.07.2017
(73) Patentinhaber: Bayerische Motoren Werke Aktiengesellschaft, 80809 München (DE)
(72) Erfinder: PROCOPIO, Andrea, 85356 Freising (DE); STOTHARD, Nigel, 81925 Muenchen (DE); UNGAR, Stefan, 84036 Landshut (DE)
(86) Internationale Anmeldenummer: PCT/EP2015/068128
(87) Internationale Veröffentlichungsnummer: WO 2016/030162

(56) Entgegenhaltungen:
- WO-A1-2013/120157
- WO-A1-2014/023615
- DE-A1-102010 002 688
- DE-A1-102010 062 114

## Beschreibung

Die vorliegende Erfindung betrifft eine Beschichtung für Metallbauteile, die insbesondere als Kolbenbeschichtung für Kolben in Verbrennungskraftmaschinen Anwendung findet sowie ein Verfahren zum Beschichten eines Metallbauteils. Darüber hinaus betrifft die Erfindung einen Kolben für Verbrennungskraftmaschinen und ein Kraftfahrzeug mit dem erfindungsgemäßen Kolben.

Zur Erhöhung der Resistenz und insbesondere für ihren Einsatz in tribologisch hoch beanspruchten Anwendungen werden Stahlbauteile zur Verschleiß- und Reibungsreduzierung mit einer abriebfesten und reibungsminimierenden Schicht beschichtet. Aus DE 10 2010 047279 A1 ist eine Beschichtung für Kolben für Verbrennungsmotoren bekannt, die aus einer verschleißbeständigen inneren Schicht aus einer Polymermatrix mit darin dispergierten Keramikpartikeln, Aramidfasern und/oder Kohlenstofffasern und einer äußeren Schicht aus einer Polymermatrix mit darin dispergierten Festschmierstoffen, besteht. Nachteilig an dieser Kolbenbeschichtung sind die reduzierte Haftung an der Kolbenoberfläche sowie ein nicht ausreichend niedriger Reibwert, insbesondere in der Einlaufzeit des Kolbens.

WO 2014/023615 A1 beschreibt ein Gleitelement, das eine Beschichtung auf einem Substrat umfasst, die zumindest eine Gleitoberfläche des Gleitelements bildet. Die Beschichtung umfasst von außen nach innen eine Carbid- oder Nitridschicht, eine Carbid-enthaltende TLC-Schicht, eine metallfreie PVD-TLC-Schicht und eine metallfreie PACVD-TLC-Schicht.

DE 10 2010 002 688 A1 beschreibt eine Schraubendruckfeder, bevorzugt aus Stahl, insbesondere CrSi- oder CrNi-Stahl, weist eine Beschichtung auf, die zumindest eine a-C:H:Me-Schicht oder alternierend mehrere Lagen von CrN- und a-C:H:Me-Schichten aufweist. Bei einem Verfahren zur Beschichtung einer Schraubendruckfeder, bevorzugt aus Stahl, werden alternierend mehrere Lagen von CrN- und a-C:H:Me-Schichten aufgebracht.

Ausgehend von diesem Stand der Technik ist es daher Aufgabe der vorliegenden Erfindung eine Beschichtung für Metallbauteile sowie einen Kolben für Verbrennungskraftmaschinen bereitzustellen, die bei hoher Abriebresistenz einen dauerhaft niedrigen Reibwert aufweisen. Darüber hinaus ist es Aufgabe der Erfindung ein Kraftfahrzeug bereitzustellen, das sich durch einen niedrigen Brennstoffverbrauch sowie eine reduzierte CO₂-Emission und Kohlenwasserstoffemission auszeichnet. Ebenfalls ist es Aufgabe der Erfindung ein Beschichtungsverfahren für Metallbauteile mit hoher Beständigkeit und guten tribologischen Eigenschaften anzugeben, das sich durch eine einfache Umsetzbarkeit auszeichnet.

Die Aufgabe wird bei einer Beschichtung für Metallbauteile erfindungsgemäß durch einen Mehrschichtaufbau gelöst. Der Mehrschichtaufbau umfasst dabei eine innere Schicht, die als Haftschicht eine direkte Verbindung mit dem Metallbauteil eingeht und einen guten Verbund zwischen der Beschichtung und dem Metallmaterial bereitstellen kann. Hierzu umfasst die innere Schicht mindestens eine Schicht, die aus einer Metallschicht, einer Metallcarbidschicht, einer Metallnitridschicht, einer Metallcarbonitridschicht und einer metallhaltigen Kohlenwasserstoffschicht ausgewählt ist, was auch Kombinationen einzelner dieser Schichten umfassen kann. Die Metalle in den jeweiligen Einzelschichten der inneren Schicht können ein Metall umfassen, oder auch dotiert zum Einsatz kommen. Besonders geeignete Dotierungselemente sind aus der Gruppe umfassend Bor (B), Stickstoff (N), Silizium (Si), Sauerstoff (O), Fluor (F), Phosphor (P), Tantal (Ta), Molybdän (Mo), Nickel (Ni), Chrom (Cr), Gold (Au), Niob (Nb), Wolfram (W), Kupfer (Cu) und Titan (Ti) ausgewählt und können je nach gewünschter zu erzielender Eigenschaft ausgewählt werden. Auch können Kombinationen mehrerer Dotierungselemente zur Anwendung kommen. Typische Gehalte der Dotierungselemente liegen zwischen 5 und 50 At%, vorzugsweise zwischen 20 und 50 At%, jeweils bezogen auf den Gesamtgehalt des jeweiligen Metalls der Einzelschicht. Der Dotierungsanteil in der inneren Schicht ist vorzugsweise graduiert und nimmt in Richtung des zu beschichtenden Metallbauteils ab. Allen Einzelschichten der inneren Schicht ist dabei gemein, dass sie einen Metallanteil aufweisen, der eine gute Verbindungsbildung mit der Metalloberfläche eingehen und somit eine gute Haftfestigkeit der Beschichtung erzielen kann.

Die innere Schicht weist eine Cr-Schicht, eine Cr/WC-Schicht und eine W-C:H-Schicht auf und die Cr-Schicht ist vorgesehen auf das Metallbauteil aufgebracht zu werden oder die innere Schicht weist eine CrN-Schicht, eine Cr/WC-Schicht und eine W-C:H-Schicht auf und die CrN-Schicht ist vorgesehen auf das Metallbauteil aufgebracht zu werden oder die innere Schicht weist eine Cr-Schicht, eine CrN-Schicht und eine Cr/WC-Schicht auf und die Cr-Schicht ist vorgesehen auf das Metallbauteil aufgebracht zu werden.Auf die innere Schicht ist eine Zwischenschicht aufgebracht, die mindestens eine Schicht aus amorphem Kohlenstoff umfasst und dadurch reibungsreduzierende Eigenschaften in die Beschichtung einträgt. Die Schicht aus amorphem Kohlenstoff ist im Einzelnen nicht beschränkt und kann je nach gewünschter physikalischer, mechanischer und chemischer Beständigkeit ausgewählt werden. Geeignete amorphe Kohlenstoffschichten sind beispielsweise aus der Richtlinie VDI 2840 bekannt.

Eine auf die Zwischenschicht aufgebrachte Deckschicht bildet eine mit der Umgebung des Metallbauteils in Verbindung stehende Oberflächenschicht. Erfindungsgemäß umfasst die Deckschicht eine W-C:H-Schicht oder eine a-C:H*-Schicht. Mit anderen Worten bildet eine W-C:H-Schicht oder eine a-C:H*-Schicht somit eine äußerste Schicht der erfindungsgemäßen Beschichtung, die mit der Umgebung eines zu beschichtenden Metallbauteils direkt in Verbindung steht.

Gemäß einer erfindungsgemäßen Alternative wird die innere Schicht durch eine Cr-Schicht, eine Cr/WC-Schicht und eine WC/W-C:H-Schicht in dieser Reihenfolge gebildet, wobei die Cr-Schicht vorgesehen ist auf das Metallbauteil aufgebracht zu werden, wobei die Zwischenschicht eine zur inneren Schicht gerichtete a-C:H-Schicht und eine zur Deckschicht gerichtete a-C:H*-Schicht umfasst und die Deckschicht eine W-C:H-Schicht ist.

Unter einer W-C:H-Schicht wird im Sinne der Erfindung eine kohlenwasserstoffhaltige Wolframschicht verstanden. Eine a-C:H*-Schicht ist eine gradierte Schicht aus amorphem Kohlenstoff, die aus diamantartigen Teilen (sp³-Hybridisierung) und graphitartigen Teilen (sp²-Hybridisierung) zusammengesetzt ist, wobei der Anteil an graphitartigen Teilen höher ist als in einer a-C:H Schicht (DCL - diamond-like carbon) und insbesondere 20 bis 50 At% beträgt und ein Anteil an diamantartigen Teilen 10 bis 30 At% beträgt. Die Härte nimmt in Richtung des Metallbauteils, also in Richtung der inneren Schicht zu, damit fällt der sp² Anteil in Richtung der inneren Schicht ab und der sp³ Anteil steigt. In der a-C:H* Schicht kann zur Härteabsenkung Stickstoff oder Wasserstoff oder ein anderweitiges Dotierungselement dotiert sein. Typische Gehalte der Dotierungselemente liegen zwischen 5 und 50 At%, vorzugsweise zwischen 20 und 50 At%. Der Dotierungsanteil in der Deckschicht ist vorzugsweise graduiert und nimmt in Richtung des zu beschichtenden Metallbauteils ab. Hierdurch kann ein besonders vorteilhafter Effekt erzielt werden: Bei Einwirkung von Reibung auf die Deckschicht werden Festschmierstoffteilchen gebildet, die eine zusätzliche Reduzierung des Reibwertes der erfindungsgemäßen Beschichtung bewirken. So wird bei bestimmungsgemäßer Anwendung beispielsweise mit Schwefel aus einem Schmieröl aus der W-C:H-Deckschicht Wolframsulfid und aus der a-C:H*-Schicht Graphit generiert. Für die Bildung von Graphit ist daher ein hoher sp²-Hybridisierungsanteil, also ein zumindest höherer Anteil an sp²-Teilen, wie er in einer herkömmlichen a-C:H-Schicht vorliegt, vorteilhaft. Die Bildung des Festschmierstoffes direkt aus der Deckschicht hat gegenüber partikulär, bspw. in einem Polymerverbund vorliegenden Festschmierstoffen, den Vorteil, dass sie selektiv dort gebildet werden, wo ein Abrieb an Deckschicht erfolgt ist, so dass die Gleiteigenschaften der Beschichtung über eine lange Zeit gleichbleibend gut sind und der übrige Schichtverbund in seiner Stabilität nicht beeinträchtigt wird.

Die erfindungsgemäßen Effekte können jedoch nur erzielt werden, wenn der Schichtverbund in sich stabil, abriebresistent und reibungsvermindernd ist. Dies wird dadurch erreicht, dass eine maximale Schichtdicke der Beschichtung maximal 5 µm beträgt. Aufgrund der hohen Abriebfestigkeit und sehr guten tribologischen Eigenschaften der erfindungsgemäßen Beschichtung ist diese insbesondere als Beschichtung für Kolben zur Anwendung in Verbrennungskraftmaschinen geeignet. Auch unter den dort auftretenden sehr großen Reibbelastungen und hohen Temperaturen ist die Beschichtung stabil und zeichnet sich durch dauerhaft niedrige Reibwerte aus. Selbst bei partiellem Abrieb der Beschichtung wird die Reibung des Kolbens in einer ihn umgebenden Laufbahn (Zylinderlaufbahn) ausreichend reduziert, da der Festschmierstoff aus der Deckschicht jederzeit durch Betrieb des Kolbens nachgebildet wird. Somit kann das System Kolben/Laufbahn schneller einlaufen, was im Hinblick auf eine Motor-Start-Stopp-Automatik, welche bei ihrem Start eine kritische Drehzahl durchläuft, besonders vorteilhaft ist.

Die Unteransprüche beinhalten vorteilhafte Weiterbildungen und Ausgestaltungen der Erfindung.

Der Schichtaufbau der inneren Schicht gemäß der vorliegenden Erfindung sieht eine Cr-Schicht (Chromschicht), eine Cr/WC-Schicht (Chrom/Wolframcarbid-Schicht) und eine W-C:H-Schicht oder eine CrN-Schicht (Chromnitrid-Schicht), eine Cr/WC-Schicht und eine W-C:H-Schicht oder eine Cr-Schicht, eine CrN-Schicht und eine Cr/WC-Schicht vor, die jeweils in dieser Reihenfolge übereinander angeordnet bzw. aufgebracht werden. Die Cr-Schicht bzw. die CrN-Schicht bildet somit die unterste Schicht der inneren Schicht. Anstelle der W-C:H-Schicht kann auch eine WC/W-C:H-Schicht verwendet werden. Die Cr-Schicht bzw. die CrN-Schicht ist vorgesehen auf das Metallbauteil aufgebracht zu werden. Diese Schichten sind aufgrund ihres Metallcharakters besonders gut geeignet mit Metallwerkstoffen, und insbesondere mit Stählen oder Aluminiumlegierungen, eine stabile, abriebfeste Verbindung einzugehen und sind zu erschwinglichen Preisen herstellbar. Die Cr/WC-Schicht dient als Stützschicht und sichert eine gute Stabilität innerhalb des Schichtverbundes in der inneren Schicht. Durch ihren Cr-Anteil kann sie mit der mit ihr verbundenen Cr-Schicht oder CrN-Schicht einen mechanisch besonders stabilen und abriebfesten Verbund eingehen. Andererseits sorgt der Wolframanteil für eine gute Verbindungsbildung zu der W-C:H-Schicht, die zusätzlich einen Beitrag zur Reibungsminimierung der erfindungsgemäßen Beschichtung leistet.

Vorteilhaft im Lichte einer Reduzierung des Reibwertes der Beschichtung für Metallbauteile umfasst die Zwischenschicht eine a-C:H-Schicht. Eine a-C:H-Schicht ist eine amorphe Kohlenstoffschicht, auch DLC (diamond-like carbon) Schicht genannt, die einen sp³-Anteil von mindestens 20 At% aufweist. Die a-C:H-Schicht kann dotiert sein, beispielsweise mit Wasserstoff (H), Si, N, P oder Sauerstoff. Typische Gehalte der Dotierungselemente liegen zwischen 5 und 50 At%, vorzugsweise zwischen 20 und 50 At%. Der Dotierungsanteil in der Zwischenschicht ist vorzugsweise graduiert und nimmt in Richtung des zu beschichtenden Metallbauteils ab.

Eine weitere vorteilhafte Weiterbildung sieht vor, dass die Zwischenschicht eine a-C:H-Schicht und eine a-C:H*-Schicht umfasst, wobei die a-C:H Schicht zur inneren Schicht und die a-C:H*-Schicht zur Deckschicht angeordnet ist. Durch den im Vergleich zur a-C:H-Schicht höheren Anteil an sp² Teilen in der a-C:H*-Schicht, nimmt die Härte der Zwischenschicht in Richtung der Deckschicht ab. Dies führt in Kombination mit der Deckschicht zu einer gut einlaufenden, weichen Toplage, die sich durch sehr gute Reibungswerte auszeichnet. In Richtung der inneren Schicht sorgt die a-C:H-Schicht aufgrund ihrer höheren Härte für eine gute Stabilität des Schichtaufbaus und eine sehr gute Haftfestigkeit im Schichtverbund.

Gemäß der vorliegenden Erfindung ist die Beschichtung für Metallbauteile alternativ dadurch gekennzeichnet, dass die innere Schicht durch eine Cr-Schicht, eine Cr/WC-Schicht und eine W-C:H-Schicht gebildet wird, und die Schichten in dieser Reihenfolge bzw. Schichtfolge auf ein Metallbauteil aufgebracht werden. Die Cr-Schicht wird dabei direkt mit dem Metallbauteil verbunden, also auf das Metallbauteil aufgebracht. Gemäß dieser Weiterbildung ist die Zwischenschicht eine a-C:H-Schicht und die Deckschicht eine W-C:H-Schicht oder eine a-C:H*-Schicht. Alternativ dazu ist die erfindungsgemäße Beschichtung für Metallbauteile dadurch gekennzeichnet, dass die innere Schicht durch eine Cr-Schicht, eine Cr/WC-Schicht und eine WC/W-C:H-Schicht in dieser Reihenfolge gebildet wird, wobei die Cr-Schicht vorgesehen ist auf das Metallbauteil aufgebracht zu werden. Die Zwischenschicht umfasst zudem eine zur inneren Schicht gerichtete a-C:H-Schicht und eine zur Deckschicht gerichtete a-C:H*-Schicht. Als Deckschicht ist eine W-C:H-Schicht vorgesehen. Diese Beschichtungen weisen ein sehr ausgeglichenes Eigenschaftsspektrum im Lichte von mechanischer Beständigkeit, Abriebfestigkeit und sehr guten tribologischen Eigenschaften auf und sind besonders gut als Beschichtung für Kolben für Verbrennungskraftmaschinen geeignet.

Ebenfalls erfindungsgemäß wird auch ein Kolben für Verbrennungskraftmaschinen beschrieben, der sich durch eine hohe Abriebfestigkeit und sehr gute Gleiteigenschaften bei sehr gutem Reib- und Verschleißverhalten auszeichnet. Der Kolben ist ein Metallbauteil im Sinne der Erfindung, beispielsweise aus Aluminium, und weist eine wie vorstehend beschriebene Beschichtung auf. Die Beschichtung kann partiell auf die Kolbenoberfläche aufgebracht sein oder aber die Kolbenlauffläche, das so genannte Kolbenhemd, vollständig umgeben. Dies hat gegenüber einer lediglich partiellen Beschichtung den Vorteil, dass der Kolben allumfänglich an seinen mit einer Kolbenlaufbahn in Verbindung stehenden Flächen beschichtet und damit vor Reibverschleiß geschützt ist. Der erfindungsgemäße Kolben weist bei ruhigem Laufverhalten, niedriger Verschleißrate und hoher Abriebfestigkeit eine hohe Laufreichweite auf durch die der Brennstoffverbrauch reduziert und damit eine CO₂-Emission und Kohlenwasserstoffemission reduziert bzw. minimiert werden kann.

Ferner erfindungsgemäß wird auch ein Kraftfahrzeug beschrieben, das mindestens einen wie vorstehend beschriebenen Kolben umfasst. Das Kraftfahrzeug ist durch einen hohen Fahrkomfort, niedrigen Brennstoffverbrauch und geringe CO₂-Emission gekennzeichnet.

Die Erfindung betrifft darüber hinaus auch ein Verfahren zum Beschichten von Metallbauteilen. Die Beschichtung wird als Mehrschichtstruktur ausgebildet. Das Verfahren umfasst die Schritte:
- Aufbringen einer inneren Schicht umfassend mindestens eine Schicht, ausgewählt aus: einer Metallschicht, einer Metallcarbidschicht Metallnitridschicht, einer Metallcarbonitridschicht, einer metallhaltigen Kohlenwasserstoffschicht und Kombinationen daraus; auf ein Metallbauteil,
   a) wobei zum Aufbringen der inneren Schicht auf das Metallbauteil nacheinander eine Cr-Schicht oder eine CrN-Schicht, eine Cr/WC-Schicht und eine W-C:H-Schicht abgeschieden werden oder wobei zum Aufbringen der inneren Schicht auf das Metallbauteil nacheinander eine Cr-Schicht, eine CrN-Schicht und eine Cr/WC-Schicht abgeschieden werden, oder
   b) wobei zum Aufbringen der inneren Schicht auf das Metallbauteil nacheinander eine Cr-Schicht, eine Cr/WC-Schicht und eine WC/W-C:H-Schicht abgeschieden werden,
- Aufbringen einer Zwischenschicht auf die innere Schicht, wobei die Zwischenschicht mindestens eine Schicht aus amorphem Kohlenstoff umfasst, und
- Aufbringen einer Deckschicht, die eine W-C:H-Schicht oder eine a-C:H*-Schicht umfasst, wobei die a-C:H*-Schicht eine gradierte Schicht aus amorphem Kohlenstoff ist, die aus diamantartigen Teilen und graphitartigen Teilen zusammengesetzt ist, wobei der Anteil an graphitartigen Teilen höher ist als in einer a-C:H Schicht, und
   wobei im Fall b) die Zwischenschicht eine zur inneren Schicht gerichtete a-C:H-Schicht und eine zur Deckschicht gerichtete a-C:H*-Schicht umfasst und die Deckschicht eine W-C:H-Schicht ist.

Die Mehrschichtstruktur wird dabei so ausgebildet, dass eine maximale Schichtdicke der Beschichtung maximal 5 µm beträgt. Bezüglich der Definitionen der einzelnen Schichten wird Bezug auf die Ausführungen zur erfindungsgemäßen Beschichtung für Metallbauteile genommen. Das Verfahren ist einfach durch das Aufbringen der jeweiligen Einzelschichten übereinander unter Anwendung von Standardprozessen ohne hohen technischen Aufwand kostengünstig umsetzbar und ermöglicht die Herstellung einer abriebfesten und mechanisch stabilen Beschichtung mit sehr guten Gleiteigenschaften und damit einem niedrigen Reibwert. Das Verfahren ist insbesondere für die Herstellung von Beschichtungen für Kolben geeignet, die in Verbrennungskraftmaschinen Anwendung finden.

Die für die erfindungsgemäße Beschichtung beschriebenen Vorteile, vorteilhaften Effekte und Weiterbildungen finden auch Anwendung auf den erfindungsgemäßen Kolben, das erfindungsgemäße Kraftfahrzeug und das erfindungsgemäße Beschichtungsverfahren für Metallbauteile.

Eine vorteilhafte Weiterbildung des erfindungsgemäßen Verfahrens sieht vor, dass das Aufbringen der Schichten mittels physikalischer oder chemischer Gasphasenabscheidung, insbesondere durch PVD oder PECVD, erfolgt. Die hier beschriebenen Prozesse sind einfach umsetzbar und erlauben die Bildung von Schichten mit einer präzisen Schichtdicke unter Vermeidung von Fehlstrukturen.

Zur Erhöhung der Abriebfestigkeit der Beschichtung von der Metalloberfläche werden gemäß dem erfindungsgemäßen Verfahren zum Aufbringen der inneren Schicht auf das Metallbauteil nacheinander eine Cr-Schicht, eine Cr/WC-Schicht und eine W-C:H-Schicht oder eine CrN-Schicht, eine Cr/WC-Schicht und eine W-C:H-Schicht oder eine Cr-Schicht, eine CrN-Schicht und eine Cr/WC-Schicht, abgeschieden.

Aufgrund der erfindungsgemäßen Lösungen sowie deren Weiterbildungen ergeben sich folgende Vorteile:
- Die Beschichtung ist abriebfest, mechanisch stabil und hält somit hohen Reibkräften stand.
- Die Beschichtung hat sehr gute tribologische Eigenschaften, also sehr gute Gleiteigenschaften bei niedrigem Reibwert und eignet sich daher insbesondere für tribologisch hoch beanspruchte Anwendungen.
- Der Kolben hat ein dauerhaft ruhiges Laufverhalten, gute Abriebresistenz und niedrige Reibungswerte in der umgebenden Kolbenlaufbahn.
- Das Kraftfahrzeug hat eine hohe Laufreichweite bei niedrigem Brennstoffverbrauch, geringen CO₂-Emissionsraten und niedrigen Kohlenwasserstoffemissionsraten.
- Das Beschichtungsverfahren ist ohne hohen technischen Aufwand durch Kombination von Standardprozessen einfach und damit auch kostengünstig umsetzbar.

Weitere Einzelheiten, Merkmale und Vorteile der Erfindung ergeben sich aus der nachfolgenden Beschreibung und den Figuren. Es zeigen:
- Figur 1: eine Beschichtung für Metallbauteile ,
- Figur 2: eine Beschichtung für Metallbauteile gemäß einer ersten Ausführungsform,
- Figur 3: eine Beschichtung für Metallbauteile gemäß einer zweiten Ausführungsform,
- Figur 4: eine Beschichtung für Metallbauteile gemäß einer dritten Ausführungsform und
- Figur 5: eine Schnittansicht eines Ausschnitts eines Kolbens gemäß einer vorteilhaften Weiterbildung.

Die vorliegende Erfindung wird anhand von Ausführungsbeispielen im Detail erläutert. In den Figuren sind nur die hier interessierenden Teile der erfindungsgemäßen Beschichtung bzw. des erfindungsgemäßen Kolbens dargestellt, alle übrigen Elemente sind der Übersichtlichkeit halber weggelassen. Ferner beziffern gleiche Bezugszeichen gleiche Elemente.

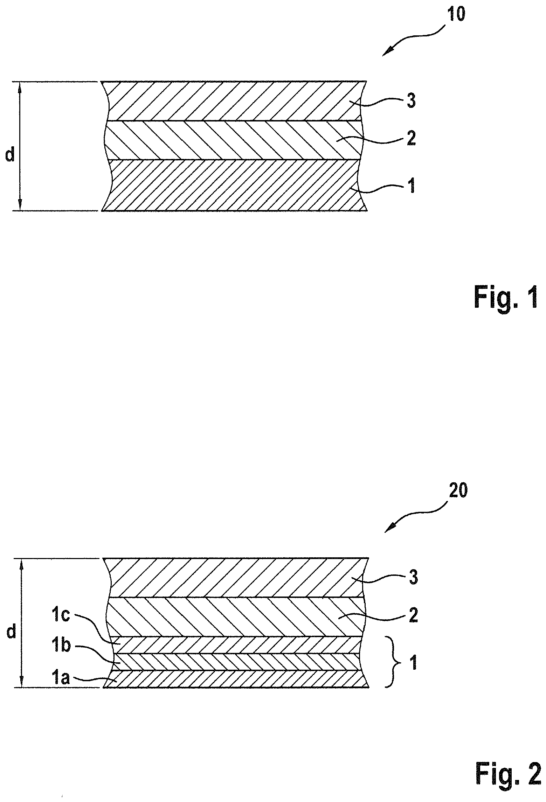

Im Detail zeigt Figur 1 einen Schichtaufbau einer Beschichtung für Metallbauteile 10, die nicht erfindungsgemäß ist. Die Beschichtung 10 umfasst drei Einzelschichten, die übereinander angeordnet sind, so dass jeweils die darüber liegende Schicht die darunter liegende Schicht bedeckt. Die erste Schicht ist eine innere Schicht 1. Die innere Schicht 1 ist dazu vorgesehen, einen direkten Kontakt mit einem Metallbauteil herzustellen und dient damit der Verbindungsbildung der Beschichtung 10 mit dem Metallbauteil. Die innere Schicht 1 umfasst mindestens eine Schicht, die aus einer Metallschicht, einer Metallcarbidschicht, einer Metallnitridschicht, einer Metallcaronitridschicht und einer metallhaltigen Kohlenwasserstoffschicht ausgewählt ist. Aufgrund des Metallanteils hat die innere Schicht 10 eine hohe Haftung an Metalloberflächen. Die Beschichtung 10 umfasst ferner eine Zwischenschicht 2, die auf der inneren Schicht 1 angeordnet ist. Die Zwischenschicht 2 umfasst mindestens eine Schicht aus amorphem Kohlenstoff, vorzugsweise aus a-C:H oder einer Kombination aus einer zur inneren Schicht gerichteten a-C:H Schicht und einer darüber angeordneten a-C:H*-Schicht. Auf der Zwischenschicht 2 ist eine Deckschicht 3 angeordnet. Die Deckschicht 3 umfasst oder wird aus einer W-C:H-Schicht oder einer a-C:H*-Schicht gebildet. Die Zwischenschicht 2 und insbesondere die Deckschicht 3 sind für die sehr guten Gleiteigenschaften der Beschichtung 10 verantwortlich. Durch Reibung ist die Deckschicht 3 befähigt Festschmierstoffe zu bilden, nämlich Wolframsulfid im Falle einer Deckschicht aus W-C:H und Graphit im Falle einer Deckschicht aus a-C:H*. Dabei ist im Falle einer a-C:H*-Deckschicht ein Anteil an sp²-Teilen in der a-C:H*-Schicht höher als ein Anteil an sp²-Teilen in einer a-C:H-Zwischenschicht. Eine maximale Schichtdicke d der Beschichtung 10 beträgt maximal 5 µm.

Figur 2 zeigt einen Schichtaufbau einer Beschichtung für Metallbauteile 20 gemäß einer ersten Ausführungsform. Die Beschichtung 20 unterscheidet sich von derjenigen aus Figur 1 dadurch, dass die innere Schicht 1 selbst eine Mehrschichtstruktur aufweist. Die innere Schicht 1 wird durch eine Cr-Schicht 1a, eine Cr/WC-Schicht 1b und eine W-C:H-Schicht 1c gebildet. Die Cr-Schicht 1a ist dabei diejenige Schicht der inneren Schicht 1, die vorgesehen ist auf ein Metallbauteil aufgebracht zu werden und eine Verbindungsbildung mit dem Metallbauteil herzustellen. Durch den Mehrschichtaufbau der inneren Schicht 1 können die Abriebfestigkeit, mechanische Stabilität und die Schichtstrukturstabilität der Beschichtung 20 verbessert werden. Eine Schichtdicke d der Beschichtung 20 beträgt ebenfalls maximal 5 µm. Alternativ zu der Cr-Schicht 1a kann auch eine CrN-Schicht verwendet werden.

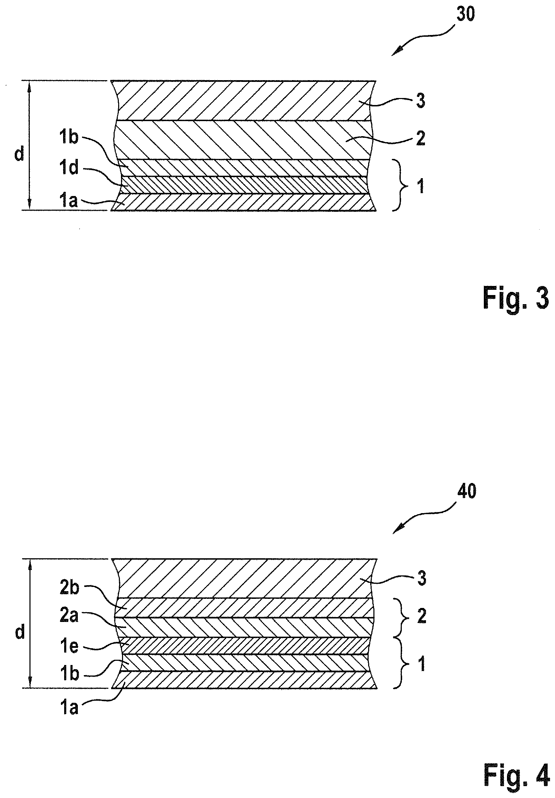

Figur 3 zeigt einen weiteren erfindungsgemäßen Schichtaufbau einer Beschichtung für Metallbauteile 30. Die Beschichtung 30 unterscheidet sich von derjenigen aus Figur 2 dadurch, dass die innere Schicht 1 eine Mehrschichtstruktur aufweist die aus einer Cr-Schicht 1a, einer CrN-Schicht 1d und einer Cr/WC-Schicht 1b gebildet wird. Die Cr-Schicht 1a ist wiederum diejenige Schicht der inneren Schicht 1, die vorgesehen ist auf ein Metallbauteil aufgebracht zu werden und eine Verbindungsbildung mit dem Metallbauteil herzustellen. Auch durch diesen Mehrschichtaufbau der inneren Schicht 1 können die Abriebfestigkeit, mechanische Stabilität und die Schichtstrukturstabilität der Beschichtung 30 verbessert werden. Eine Schichtdicke d der Beschichtung 30 beträgt ebenfalls maximal 5 µm.

Figur 4 zeigt einen Schichtaufbau einer Beschichtung für Metallbauteile 40 gemäß einer dritten Ausführungsform. Die Beschichtung 40 umfasst wiederum einen dreischichtigen Schichtaufbau der inneren Schicht 1, der eine Cr-Schicht 1a, eine Cr/WC-Schicht 1b und eine WC/WC:H-Schicht 1e umfasst. Im Unterschied zu den Beschichtungen aus Figuren 1 bis 3 ist die Zwischenschicht 2 eine Zweischichtstruktur, die eine zur inneren Schicht 1 gerichtete a-C:H-Schicht 2a und eine zur W-C:H Deckschicht 3 gerichtete a-C:H*-Schicht 2b aufweist. Auch durch diesen Schichtaufbau kann eine Beschichtung 40 mit sehr guten tribologischen Eigenschaften und hoher Haftfestigkeit erhalten werdne. Eine Schichtdicke d der Beschichtung 30 beträgt maximal 5 µm.

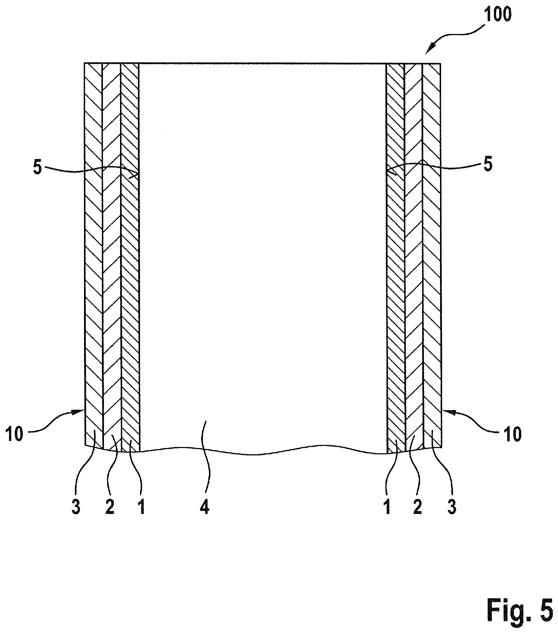

Figur 5 ist eine Schnittansicht durch einen Kolben 100. Der Kolben 100 ist ein Metallbauteil im Sinne der Erfindung und kann von zylindrischer Geometrie sein. Der Kolben 100 umfasst ein Kolbenvolumen 4. Die das Kolbenvolumen 4 begrenzenden Seitenflächen 5 sind diejenigen Flächen, die bei Betrieb des Kolbens 100, beispielsweise in einer Verbrennungskraftmaschine, in Reibkontakt mit einer Kolbenlaufbahn stehen und werden auch als Gleitflächen oder als Kolbenhemd bezeichnet. Die Seitenflächen 5 weisen eine Beschichtung 10 auf, die hier beispielhaft aus drei Einzelschichten gebildet und somit wie diejenige Beschichtung 10 aus Figur 1 anzusehen ist. Diese Ausführungsform ist nicht erfindungsgemäß. Im Rahmen der Erfindung ist es möglich, dass die innere Schicht 1 mehrere Einzelschichten, beispielsweise wie die innere Schicht 1 aus Figuren 2 bis 4 umfasst oder die Zwischenschicht 2 und/oder die Deckschicht 3 vielschichtig aufgebaut sind.

In dem in Figur 5 gezeigten Ausschnitt des Kolbens 100 dient eine innere Schicht 1 der Haftverbindung zwischen der Seitenfläche 5 des Kolbens 100 und der Beschichtung 10. Eine Zwischenschicht 2 und eine Deckschicht 3 sind auf der inneren Schicht 1 angeordnet. Die Deckschicht 3 liegt an der Oberfläche des Kolbens 100 und ermöglicht bei bestimmungsgemäßem Gebrauch des Kolbens 100 ein reibungsminimiertes Gleiten des Kolbens 100 in seiner Kolbenlaufbahn. Die einzelnen Schichten können auf die Seitenflächen 5 des Kolbens 100 vorzugsweise mittels physikalischer oder chemischer Gasphasenabscheidung, insbesondere durch PVD oder PECVD, aufgebracht werden. Der Kolben 100 ist hoch verschleißresistent, abriebfest und weist sehr gute tribologische Eigenschaften auf, die eine hohe Laufleistung bei reduziertem Brennstoffverbrauch und damit geringer CO₂-Emission sowie Kohlenwasserstoffemission ermöglichen.

Die vorhergehende Beschreibung der vorliegenden Erfindung dient nur zu illustrativen Zwecken und nicht zum Zwecke der Beschränkung der Erfindung. Im Rahmen der Erfindung sind verschiedene Änderungen und Modifikationen möglich, ohne den Umfang der Erfindung sowie ihrer Äquivalente zu verlassen.

### Bezugszeichenliste:

- 1: innere Schicht
- 1a: Cr-Schicht
- 1b: Cr/WC-Schicht
- 1c: W-C:H-Schicht
- 1d: CrN-Schicht
- 1e: WC/WC:H-Schicht
- 2: Zwischenschicht
- 2a: a-C:H-Schicht
- 2b: a-C:H*-Schicht
- 3: Deckschicht
- 4: Kolbenvolumen
- 5: Seitenfläche des Kolbens
- 10: Beschichtung
- 20: Beschichtung
- 30: Beschichtung
- 40: Beschichtung
- 100: Kolben

## Patentansprüche

1. Beschichtung für Metallbauteile, insbesondere Kolbenbeschichtung zur Anwendung in Verbrennungskraftmaschinen, umfassend eine innere Schicht (1), die auf das Metallbauteil aufgebracht wird, eine Zwischenschicht (2) und eine Deckschicht (3), wobei die innere Schicht (1) mindestens eine Schicht, ausgewählt aus: einer Metallschicht, einer Metallcarbidschicht, einer Metallnitridschicht, einer Metallcarbonitridschicht und einer metallhaltigen Kohlenwasserstoffschicht; die Zwischenschicht (2) mindestens eine Schicht aus amorphem Kohlenstoff und die Deckschicht (3) eine W-C:H-Schicht oder eine a-C:H*-Schicht umfasst, wobei die a-C:H*-Schicht eine gradierte Schicht aus amorphem Kohlenstoff ist, die aus diamantartigen Teilen und graphitartigen Teilen zusammengesetzt ist, wobei der Anteil an graphitartigen Teilen höher ist als in einer a-C:H Schicht, und wobei eine maximale Schichtdicke (d) der Beschichtung maximal 5 µm beträgt, **dadurch gekennzeichnet, dass**
i) die innere Schicht (1) eine Cr-Schicht (1a), eine Cr/WC-Schicht (1b) und eine W-C:H-Schicht (1c) aufweist und die Cr-Schicht (1a) vorgesehen ist auf das Metallbauteil aufgebracht zu werden oder dass die innere Schicht (1) eine CrN-Schicht (1d), eine Cr/WC-Schicht (1b) und eine W-C:H-Schicht (1c) aufweist und die CrN-Schicht (1d) vorgesehen ist auf das Metallbauteil aufgebracht zu werden oder dass die innere Schicht (1) eine Cr-Schicht (1a), eine CrN-Schicht (1d) und eine Cr/WC-Schicht (1b) aufweist und die Cr-Schicht (1a) vorgesehen ist auf das Metallbauteil aufgebracht zu werden oder
ii) die innere Schicht (1) durch eine Cr-Schicht (1a), eine Cr/WC-Schicht (1b) und eine WC/W-C:H-Schicht (1e) in dieser Reihenfolge gebildet wird, wobei die Cr-Schicht (1a) vorgesehen ist auf das Metallbauteil aufgebracht zu werden, die Zwischenschicht (2) eine zur inneren Schicht (1) gerichtete a-C:H-Schicht (2a) und eine zur Deckschicht (3) gerichtete a-C:H*-Schicht (2b) umfasst und die Deckschicht (3) eine W-C:H-Schicht ist.

2. Beschichtung für Metallbauteile nach Anspruch 1, **dadurch gekennzeichnet, dass** gemäß i) die Zwischenschicht (2) eine a-C:H-Schicht (2a) umfasst.

3. Beschichtung für Metallbauteile nach einem der vorhergehenden Ansprüche, **dadurch gekennzeichnet, dass** gemäß i) die Zwischenschicht (2) eine a-C:H-Schicht (2a) und eine a-C:H*-Schicht (2b) umfasst, wobei die a-C:H-Schicht (2a) zur inneren Schicht (1) und die a-C:H*-Schicht (2b) zur Deckschicht (3) gerichtet ist.

4. Beschichtung für Metallbauteile nach einem der vorhergehenden Ansprüche, **dadurch gekennzeichnet, dass** gemäß i) die innere Schicht (1) durch eine Cr-Schicht (1a) oder CrN-Schicht (1d), eine Cr/WC-Schicht (1b) und eine W-C:H-Schicht (1c) in dieser Reihenfolge gebildet wird, wobei die Cr-Schicht (1a) oder die CrN-Schicht (1d) vorgesehen ist auf das Metallbauteil aufgebracht zu werden, die Zwischenschicht (2) eine a-C:H-Schicht und die Deckschicht (3) eine W-C:H-Schicht oder eine a-C:H*-Schicht ist.

5. Kolben für Verbrennungskraftmaschinen, umfassend eine Beschichtung (10, 20) nach einem der vorhergehenden Ansprüche.

6. Kraftfahrzeug umfassend mindestens einen Kolben (100) nach Anspruch 5.

7. Verfahren zum Beschichten von Metallbauteilen, insbesondere von Verbrennungsmotorkolben, umfassend die Schritte:
- Aufbringen einer inneren Schicht (1) umfassend mindestens eine Schicht, ausgewählt aus: einer Metallschicht, einer Metallcarbidschicht, einer Metallnitridschicht, einer Metallcarbonitridschicht, einer metallhaltigen Kohlenwasserstoffschicht und Kombinationen daraus; auf ein Metallbauteil,
a) wobei zum Aufbringen der inneren Schicht (1) auf das Metallbauteil nacheinander eine Cr-Schicht (1a) oder eine CrN-Schicht (1d), eine Cr/WC-Schicht (1b) und eine W-C:H-Schicht (1c) abgeschieden werden oder wobei zum Aufbringen der inneren Schicht (1) auf das Metallbauteil nacheinander eine Cr-Schicht (1a), eine CrN-Schicht (1d) und eine Cr/WC-Schicht (1c) abgeschieden werden oder
b) wobei zum Aufbringen der inneren Schicht (1) auf das Metallbauteil nacheinander eine Cr-Schicht (1a), eine Cr/WC-Schicht (1b) und eine WC/W-C:H-Schicht (1e) abgeschieden werden,
- Aufbringen einer Zwischenschicht (2) auf die innere Schicht, wobei die Zwischenschicht (2) mindestens eine Schicht aus amorphem Kohlenstoff umfasst und
- Aufbringen einer Deckschicht (3), die eine W-C:H-Schicht oder eine a-C:H*-Schicht umfasst, wobei die a-C:H*-Schicht eine gradierte Schicht aus amorphem Kohlenstoff ist, die aus diamantartigen Teilen und graphitartigen Teilen zusammengesetzt ist, wobei der Anteil an graphitartigen Teilen höher ist als in einer a-C:H Schicht,
wobei im Fall b) die Zwischenschicht (2) eine zur inneren Schicht (1) gerichtete a-C:H-Schicht (2a) und eine zur Deckschicht (3) gerichtete a-C:H*-Schicht (2b) umfasst und die Deckschicht (3) eine W-C:H-Schicht ist, und
wobei eine Schichtdicke (d) der Beschichtung maximal 5 µm beträgt.

8. Verfahren nach Anspruch 7, **dadurch gekennzeichnet, dass** das Aufbringen der Schichten mittels physikalischer oder chemischer Gasphasenabscheidung, insbesondere durch PVD oder PECVD, erfolgt.

## Claims

1. A coating for metal components, especially a piston coating for use in internal combustion engines, comprising an inner layer (1) which is applied to the metal component, an intermediate layer (2) and a top layer (3), wherein the inner layer (1) comprises at least one layer, selected from: a metal layer, a metal carbide layer, a metal nitride layer, a metal carbonitride layer and a metal-containing hydrocarbon layer; the intermediate layer (2) comprises at least one layer made of amorphous carbon and the top layer (3) comprises a W-C:H layer or an a-C:H* layer, wherein the a-C:H* layer is a graded layer made of amorphous carbon which is composed of diamond-like portions and graphite-like portions, wherein the proportion of graphite-like portions is higher than in an a-C:H layer, and wherein a maximum layer thickness (d) of the coating is at most 5 µm, **characterised in that**
i) the inner layer (1) has a Cr layer (1a), a Cr/WC layer (1b) and a W-C:H layer (1c) and the Cr layer (1a) is provided for application to the metal component, or **in that** the inner layer (1) has a CrN layer (1d), a Cr/WC layer (1b) and a W-C:H layer (1c), and the CrN layer (1d) is provided for application to the metal component, or **in that** the inner layer (1) has a Cr layer (1a), a CrN layer (1d) and a Cr/WC layer (1b) and the Cr layer (1a) is provided for application to the metal component, or
ii) the inner layer (1) is formed by a Cr layer (1a), a Cr/WC layer (1b) and a WC/W-C:H layer (1e) in this sequence, wherein the Cr layer (1a) is provided for application to the metal component, the intermediate layer (2) comprises an a-C:H layer (2a) directed at the inner layer (1) and an a-C:H* layer (2b) directed at the top layer (3), and the top layer (3) is a W-C:H layer.

2. A coating for metal components according to Claim 1, **characterised in that** in i) the intermediate layer (2) comprises an a-C:H layer (2a).

3. A coating for metal components according to one of the preceding claims, **characterised in that** in i) the intermediate layer (2) comprises an a-C:H layer (2a) and an a-C:H* layer (2b), the a-C:H layer (2a) being directed at the inner layer (1) and the a-C:H* layer (2b) being directed at the top layer (3).

4. A coating for metal components according to one of the preceding claims, **characterised in that** in i) the inner layer (1) is formed by a Cr layer (1a) or CrN layer (1d), a Cr/WC layer (1b) and a W-C:H layer (1c) in this sequence, the Cr layer (1a) or the CrN layer (1d) being provided for application to the metal component, the intermediate layer (2) being an a-C:H layer and the top layer (3) a W-C:H layer or an a-C:H* layer.

5. A piston for internal combustion engines, comprising a coating (10, 20) according to one of the preceding claims.

6. A motor vehicle comprising at least one piston (100) according to Claim 5.

7. A method for coating metal components, especially internal-combustion engine pistons, comprising the steps:
- applying an inner layer (1) comprising at least one layer, selected from: a metal layer, a metal carbide layer, a metal nitride layer, a metal carbonitride layer, a metal-containing hydrocarbon layer and combinations thereof; to a metal component,
a) wherein to apply the inner layer (1) to the metal component a Cr layer (1a) or a CrN layer (1d), a Cr/WC layer (1b) and a W-C:H layer (1c) are deposited in succession, or wherein to apply the inner layer (1) to the metal component a Cr layer (1a), a CrN layer (1d) and a Cr/WC layer (1c) are deposited in succession, or
b) wherein to apply the inner layer (1) to the metal component a Cr layer (1a), a Cr/WC layer (1b) and a WC/W-C:H layer (1e) are deposited in succession,
- applying an intermediate layer (2) to the inner layer, wherein the intermediate layer (2) comprises at least one layer made of amorphous carbon, and
- applying a top layer (3) which comprises a W-C:H layer or an a-C:H* layer, wherein the a-C:H* layer is a graded layer made of amorphous carbon which is composed of diamond-like portions and graphite-like portions, wherein the proportion of graphite-like portions is higher than in an a-C:H layer,
wherein in case b) the intermediate layer (2) comprises an a-C:H layer (2a) directed at the inner layer (1) and an a-C:H* layer (2b) directed at the top layer (3) and the top layer (3) is a W-C:H layer, and
wherein a layer thickness (d) of the coating is at most 5 µm.

8. A method according to Claim 7, **characterised in that** the application of the layers takes place by means of physical or chemical vapour deposition, especially by PVD or PECVD.

## Revendications

1. Revêtement destiné à des pièces métalliques, en particulier revêtement de piston destiné à être utilisé dans des moteurs à combustion interne comprenant une couche interne (1) qui est appliquée sur la pièce métallique, une couche intermédiaire (2) et une couche de recouvrement (3), la couche interne (1) comprenant au moins une couche choisie parmi une couche métallique, une couche en carbure métallique, une couche en nitrure métallique, une couche en carbonitrure métallique et une couche d'hydrocarbure renfermant un métal, la couche intermédiaire (2) comprenant au moins une couche en carbone amorphe et la couche de recouvrement (3) comprenant une couche W-C:H ou une couche a-C:H*, la couche a-C:H* étant une couche graduée en carbone amorphe, qui est composée d'éléments de type diamant et d'éléments de type graphite, la proportion d'éléments de type graphite étant supérieure à la proportion de tels éléments dans une couche a-C:H, et l'épaisseur de couche maximum (d) du revêtement étant d'au moins 5µm,
**caractérisé en ce que**
i) la couche interne (1) comporte une couche Cr (1a) une couche Cr/WC (1b) et une couche W-C:H (1c), et la couche Cr (1a) est destinée à être appliquée sur la pièce métallique, ou, la couche interne (1) comporte une couche CrN (1d), une couche Cr/WC (1b) et une couche W-C:H (1c), et la couche CrN (1d) est destinée à être appliquée sur la pièce métallique, ou la couche interne (1) comporte une couche Cr (1a) une couche CrN (1d) et une couche Cr/WC (1b), et la couche Cr (1a) est destinée à être appliquée sur la pièce métallique, ou
ii) la couche interne (1) est formée par une couche Cr (1a), une couche Cr/WC (1b) et une couche WC/W-C:H (1e) dans cet ordre, et la couche Cr (1a) est destinée à être appliquée sur la pièce métallique, la couche intermédiaire (2) comportant une couche a-C:H (2a) orientée vers la couche interne (1) et une couche a-CH* (2b) orientée vers la couche de recouvrement (3) étant la couche de recouvrement (3) étant une couche W-C:H.

2. Revêtement destiné à de pièces métalliques, conforme à la revendication 1,
**caractérisé en ce que**
selon la caractéristique i) la couche intermédiaire (2) comporte une couche a-C:H (2a).

3. Revêtement destiné à des pièces métalliques, conforme à l'une des revendications précédentes,
**caractérisé en ce que**
selon la caractéristique i) la couche intermédiaire (2) comporte une couche a-C:H (2a) et une couche a-C:H* (2b), la couche a-C:H (2a) étant orientée vers la couche interne (1) et la couche a-C:H* (2b) étant orientée vers la couche de recouvrement (3).

4. Revêtement destiné à des pièces métalliques conforme à l'une des revendications précédentes,
**caractérisé en ce que**
selon la caractéristique i) la couche interne (1) est formée par une couche Cr (1a) ou une couche CrN (1d), une couche Cr/WC (1b) et une couche W-C:H (1c), dans cet ordre, et la couche Cr (1a) ou la couche CrN (1d) est destinée à être appliquée sur la pièce métallique, la couche intermédiaire (2) étant une couche a-C:H et la couche de recouvrement (3) étant une couche W-C:H ou une couche a-C:H*.

5. Piston destiné à des moteurs à combustion interne, comprenant un revêtement (10, 20) conforme à l'une des revendications précédentes.

6. Véhicule comprenant au moins un piston (100) conforme à la revendication 5.

7. Procédé de revêtement de pièces métalliques en particulier de pistons de moteurs à combustion interne comprenant des étapes consistant à :
- appliquer une couche interne (1) comprenant au moins une couche choisie parmi une couche métallique, une couche en carbure métallique, une couche en nitrure métallique, une couche en carbonitrure métallique ou une couche d'hydrocarbure renfermant un métal et des combinaisons de telles couches sur une pièce métallique, étape selon laquelle
a) pour appliquer la couche interne (1) sur la pièce métallique, on dépose successivement une couche Cr (1a) ou une couche CrN (1d), une couche Cr/WC (1b) et une couche W-C:H (1c), ou pour appliquer la couche interne (1) sur la pièce métallique on dépose successivement une couche Cr (1a) une couche CrN (1d) et une couche Cr/WC (1c), ou
b) pour appliquer la couche interne (1) sur la pièce métallique on dépose successivement une couche Cr (1a) une couche Cr/WC (1b) et une couche WC/W-C:H (1e),
- appliquer une couche intermédiaire (2) sur la couche interne, la couche intermédiaire (2) renfermant au moins une couche en carbone amorphe, et
- appliquer une couche de recouvrement (3) qui renferme une couche W-C:H ou une couche a-C:H*, la couche a-C:H* étant une couche graduée en carbone amorphe qui est composée d'éléments de type diamant et d'éléments de type graphite, la proportion d'éléments de type graphite étant supérieure à la proportion de tels éléments dans une couche a-C:H,
- dans le cas b), la couche intermédiaire (2) comprenant une couche a-C:H (2a) orientée vers la couche interne (1) et une couche a-C:H* (2b) orientée vers la couche de recouvrement (3), et, la couche de recouvrement (3) étant une couche W-C:H, et
- l'épaisseur de couche (d) du revêtement étant au maximum de 5 µm.

8. Procédé conforme à la revendications 7,
**caractérisé en ce que**
l'application des couches est effectuée par dépôt physique ou chimique en phase gazeuse, en particulier par le procédé PVD ou par le procédé PECVD.
